# EUROPÄISCHE PATENTANMELDUNG

(11) **EP 3 035 392 A1**
(43) Veröffentlichungstag der Anmeldung: **22.06.2016**
(21) Anmeldenummer: 15192751.4
(22) Anmeldetag: 25.08.2010
(51) Int. Cl.: H01L 31/02, H01L 31/042

(54) **BYPASS- UND SCHUTZSCHALTUNG FÜR EIN SOLARMODUL UND VERFAHREN ZUM STEUERN EINES SOLARMODULS**

(30) Priorität: 26.08.2009 DE 102009038601; 19.10.2009 DE 102009049922
(62) Teilanmeldung aus: 10747618.6
(71) Anmelder: Fraunhofer-Gesellschaft zur Förderung der angewandten Forschung e.V., 80686 München (DE)
(72) Erfinder: Schmidt, Heribert, 79177 Freiburg (DE); Roth, Werner, 79106 Freiburg (DE)
(74) Vertreter: Zimmermann, Tankred Klaus

(57) **Zusammenfassung**

Eine Bypass- und Schutzschaltung für ein Solarmodul (130) umfasst einen Eingang (102, 104) zum Anschluss des Solarmoduls (130), einen Ausgang (106, 108), ein Bypass-Element (112), das parallel zu dem Ausgang (106, 108) geschaltet ist, ein Trenn-Element (110), das zwischen den Eingang und den Ausgang geschaltet ist und konfiguriert ist, um die Verbindung zwischen dem Eingang und dem Ausgang zu steuern. Das Trenn-Element (110) ist konfiguriert ist, um eine Verbindung zwischen dem Eingang (102, 104) und dem Ausgang (106, 108) abhängig davon zu steuern, ob das der Schaltung (100) zugeordnete Solarmodul (130) ganz oder teilweise abgeschattet ist; und einer Steuerung (114), die wirksam mit dem Trenn-Element (110) verbunden ist und konfiguriert ist, um ein Steuersignal für das Trenn-Element (110) zu erzeugen, wobei die Steuerung (114) konfiguriert ist, um basierend auf den am Eingang und am Ausgang anliegenden Leistungssignalen zu bestimmen, ob eine teilweise oder vollständige Abschattung des der Schaltung (100) zugeordneten Solarmoduls (130) vorliegt, und um das Steuersignal zu erzeugen, falls bestimmt wird, dass das der Schaltung (100) zugeordnete Solarmodul (130) ganz oder teilweise abgeschattet ist.

## Beschreibung

Die vorliegende Erfindung bezieht sich auf das Gebiet der Solartechnologie, und hier insbesondere auf eine Bypass- und Schutzschaltung für ein Solarmodul sowie auf ein Verfahren zum Steuern eines Solarmoduls, welches durch ein Bypass-Element überbrückt ist.

Beim Betrieb von Solarmodulen können verschiedene Situationen eintreten, in denen entweder die Solarmodule nicht mehr im optimalen Arbeitspunkt arbeiten, oder in denen aufgrund von internen oder externen Bedingungen eine Schädigung der Solarmodule erfolgen kann. Ebenso können Situationen auftreten, in denen Solarmodule eine Gefahr für ihre Umgebung darstellen.

Bei einer Reihenschaltung von Solarzellen entsteht bei einer inhomogenen Beleuchtung/einer Teilabschattung oder auch bei unterschiedlichen Eigenschaften der Solarzellen, insbesondere des Kurzschlussstroms, das Problem, dass zum einen die betroffenen Zellen den Stromfluss im Gesamtkreis bestimmen, zum anderen sich die Spannung an diesen Zellen umkehrt, sie also zum Verbraucher werden und im schlimmsten Fall geschädigt werden können. Im Folgenden werden unabhängig von der tatsächlichen Ursache dieser Spannungsumkehr die Begriffe "Abschattung" oder "Abschattungsfall" genutzt. Eine bekannte Maßnahme zur Vermeidung einer Schädigung ist die Nutzung von sogenannten Bypass-Dioden, die im Allgemeinen in einem Solarmodul parallel zu Untergruppen von z.B. 16 bis 24 kristallinen Solarzellen geschaltet werden. Im Nonnalbetrieb werden die Bypass-Dioden in der Sperrrichtung betrieben. Im Fall einer Teilabschattung sind die Bypass-Dioden in Durchlassrichtung gepolt und übernehmen den durch die nicht abgeschatteten Zellen hervorgerufenen Strangstrom. In diesem Fall geht die Arbeitspunktspannung über dem betroffenen Teilabschnitt des Solargenerators von dem Normalbetrieb ca. +8 V bis +12 V (unter Zugrundelegung einer MPP-Spannung von 16 bis 24 Zellen) auf die Durchlassspannung der Bypass-Diode zurück, also auf ca. -0,4 V bis -0,6 V.

Der maximale Strom durch die Bypass-Diode ist abhängig von der Zelltechnologie und der Zellgröße, wobei mit heute üblichen Siliziumzellen mit einer Fläche von 156 mm x 156 mm der maximale Strom bis zu 8,5 A betragen kann. Aufgrund größerer Zellflächen und auch höherer Wirkungsgrade der eingesetzten Solarzellen ist für die Zukunft mit noch höheren Strömen im Bereich von mehr als 10 A zu rechnen.

Als Bypass-Dioden werden typischerweise handelsübliche Silizium pn-Dioden, aber auch Schottky-Dioden, eingesetzt, wobei neuere Entwicklungen auch MOSFETs als aktive Bypass-Elemente einsetzen.

Die Bypass-Dioden verursachen im Normalbetrieb, also ohne Abschattung, nahezu keine Verluste, da sie in Sperrrichtung betrieben werden und nur ein geringer Sperrstrom durch sie fließt. Im Abschattungsfall kann aber der gesamte, von den nicht abgeschatteten in Reihe verschalteten Modulen hervorgerufene Strom durch die Bypass-Diode fließen. Entsprechend ihrer Durchlassspannung und dem durchfließenden Strom entsteht dann eine Verlustleistung von mehreren Watt pro Diode, die bei länger andauernden Abschattungen zu einer starken Erwärmung des Bauteils führt. Diese Erwärmung wirkt sich negativ auf die umgebenden Modulkomponenten aus, wie beispiele die Anschlussdose, das Anschlusskabel oder auf den Modulaufbau, und im schlimmsten Fall kommt es zu einer Schädigung der Komponenten oder der Bypass-Diode selbst.

In der DE 10 2005 036 153 B4 wird vorgeschlagen, die Diode durch ein aktives Bauelement, nämlich einen niederohmigen MOSFET, zu ersetzen, welcher im Falle einer Abschattung aktiviert wird. Durch diese Maßnahme lässt sich die dann noch entstehende Verlustleistung um z.B. einen Faktor 20 oder mehr reduzieren, womit die oben genannten Probleme der Überhitzung nicht mehr auftreten. Zielsetzung bei dieser Lösung ist es, eine Schaltung oder ein Bauteil zu schaffen, welches anschlusskompatibel zu konventionellen Dioden ist, also ebenfalls nur über zwei Anschlüsse verfügt. Dabei entsteht jedoch die Problematik, dass im Abschattungsfall nur die über dem aktiven Bypass-Element abfallende, sehr geringe Spannung zur Ansteuerung des Bypass-Elements zur Verfügung steht, so dass gemäß den Lehren der DE 10 2005 036 153 B4 zusätzlich eine Ladeschaltung vorgesehen sein muss, die in Verbindung mit einer Trennschaltung angeordnet ist, um die verfügbare Spannung im Millivoltbereich in eine geeignete Steuerspannung im Bereich von 10 bis 15 V umzusetzen. Somit erfordert diese Lösung einen hohen schaltungstechnischen Aufwand, insbesondere im Zusammenhang mit der Realisierung der Ladeschaltung, beispielsweise in Form eines Drossel- oder Sperrwandlers oder auch in der Ausgestaltung als Niederspannungs-Ladungspumpe. Dies erschwert und verteuert die Realisierung einer aktiven Bypass- und Schutzschaltung als integrierte Schaltung.

Solarmodule haben weiterhin die Eigenschaft, dass sie elektrische Spannung erzeugen, solange sie bestrahlt sind, was bedeutet, dass sie nicht abschaltbar sind. Dies erfordert besondere Vorsichtsmaßnahmen bei der Installation und Wartung. Problematisch ist auch die oftmals hohe Solargeneratorspannung von mehreren hundert Volt im Falle eines Hausbrandes mit einem auf dem Dach montierten Solargenerator.

Handelsübliche Solarmodule verfügen nicht über die Möglichkeit einer Abschaltung. In der DE 10 2005 036 153 B4, die oben erwähnt wurde, wird vorgeschlagen, das aktive Bypass-Element auch zum gezielten Abschalten bzw. Einschalten des Moduls über ein externes Steuersignal zu nutzen. Ein weiterer Ansatz zur Abschaltung von Solargeneratoren wird durch das Unternehmen Aixcon (www.aixcon.de) mit dem System "ebreak" vorgeschlagen, gemäß dem der gesamte Solargenerator im Notfall über einen einzelnen Schalter, beispielsweise einen Thyristor, kurzgeschlossen wird. Dies löst jedoch das grundsätzliche Problem nicht, da damit nur die hinter dieser Einheit weiterführenden Leitungen spannungsfrei geschaltet werden, bei einem Auftrennen der Modulverbindung auf dem Dach dort aber wieder eine hohe Spannung anstehen wird. Die generelle Möglichkeit eines gezielten Freischaltens von einzelnen Solarmodulen mittels eines externen Signals wird auch in der DE 10 2006 060 815 A1 beschrieben, wobei hier sowohl das Kurzschließen der Solarmodule als auch das Auftrennen der Serienverbindung dargestellt wird, ohne dass Details einer Realisierung angegeben werden. Die hier vorgeschlagene Lösung unter Verwendung eines Serienschalters ist nachteilhaft, da dieser hinsichtlich seiner Spannungsfestigkeit auf die maximale Systemspannung ausgelegt sein muss, beispielsweise auf bis zu 1000 V, da in einer Reihenschaltung von vielen Modulen nicht sichergestellt sein kann, dass alle Schalter synchron öffnen. Ein solcher Schalter ist aufwendig und erzeugt durch seinen vergleichsweise hohen Einschaltwiderstand immer eine hohe Verlustleistung, und führt zu den weiter oben beschriebenen Problemen im Hinblick auf die Wärmeentwicklung und die damit einhergehende Gefahr von Beschädigungen. Die Lösung unter Verwendung eines parallelen Schalters hat ebenfalls die oben genannten Nachteile einer aufwendigen Bereitstellung der erforderlichen Versorgungsspannung und ferner den Nachteil, dass ein Betriebs des Moduls im Kurzschluss die Wahrscheinlichkeit einer Schädigung durch sogenannte "Hotspots" vergrößert.

Die Abschaltung eines Solarmoduls durch einen parallelen Schalter wird ferner in der oben erwähnten DE 10 2005 036 153 B4 der Anmelderin erwähnt.

Der vorliegenden Erfindung liegt somit die Aufgabe zugrunde, eine verbesserte Bypass- und Schutzschaltung für ein Solarmodul sowie ein verbessertes Verfahren zum Steuern eines Solarmoduls, das durch ein Bypass-Element überbrückt ist, zu schaffen.

Diese Aufgabe wird durch eine Bypass-Schaltung gemäß Anspruch 1 und durch ein Verfahren gemäß Anspruch 13 gelöst.

Ausführungsbeispiele der Erfindung schaffen eine Bypass- und Schutzschaltung für ein Solarmodul, mit:
einem Eingang zum Anschluss des Solarmoduls;
einem Ausgang;
einem Bypass-Element, das parallel zu dem Ausgang geschaltet ist; und
einem Trenn-Element, das zwischen den Eingang und den Ausgang geschaltet ist und konfiguriert ist, um die Verbindung zwischen dem Eingang und dem Ausgang zu steuern;
wobei das Trenn-Element konfiguriert ist, eine Verbindung zwischen dem Eingang und dem Ausgang abhängig davon zu steuern, ob das der Schaltung zugeordnete Solarmodul ganz oder teilweise abgeschattet ist, oder ob das der Schaltung zugeordnete Solarmodul ein- oder ausgeschaltet sein soll.

Gemäß einem Ausführungsbeispiel bewirkt das Steuersignal eine Unterbrechung der normalerweise geschlossenen Verbindung zwischen dem Eingang und dem Ausgang der Schaltung, wenn das der Schaltung zugeordnete Solarmodul ganz oder teilweise abgeschattet ist, oder wenn das der Schaltung zugeordnete Solarmodul ausgeschaltet werden soll. Ebenso kann die Schaltung konfiguriert sein, um das Herstellen einer normalerweise offenen Verbindung zwischen dem Eingang und dem Ausgang zu bewirken, wenn das der Schaltung zugeordnete Solarmodul eingeschaltet werden soll. Gemäß Ausführungsbeispielen ist die Schaltung mit dem Solarmodul derart verschaltbar, dass eine Unterbrechung der Verbindung durch das Trenn-Element einen Leerlaufbetrieb des Solarmoduls bewirkt.

Die Schaltung kann entweder einen Steuersignalanschluss zum Empfangen des Steuersignals aufweisen, oder das Steuersignal kann über einen Eingang und/oder über den Ausgang der Schaltung empfangen werden. Gemäß einem Ausführungsbeispiel umfasst die Schaltung eine Steuerung, die wirksam mit dem Trenn-Element verbunden ist, und konfiguriert ist, um das Steuersignal zu erzeugen. In diesem Fall kann die Steuerung einen Leistungsversorgungsanschluss aufweisen, der mit dem Eingang der Schaltung verbunden ist. Die Steuerung kann konfiguriert sein, um basierend auf den am Eingang und am Ausgang anliegenden Leistungssignalen zu bestimmen, ob eine teilweise oder vollständige Abschattung des der Bypass-Schutzschaltung zugeordneten Solarmoduls vorliegt, und um das Steuersignal zu erzeugen, falls bestimmt wird, dass das Solarmodul ganz oder teilweise abgeschattet ist. In diesem Fall kann vorgesehen sein, das eigentliche Bypass-Element ebenfalls durch ein Steuersignal anzusteuern, wobei auch dieses durch die Steuerung erzeugt wird, falls bestimmt wird, dass das Solarmodul ganz oder teilweise abgeschattet ist. Die Steuerung kann ferner konfiguriert sein, um nach dem Bestimmen eines ganz oder teilweise abgeschatteten Zustands zu überprüfen, ob die Abschattungssituation noch andauert, um ein Zurückschalten in den Normalzustand zu bewirken, falls keine Abschattungssituation mehr vorliegt.

Gemäß einem Aspekt der Erfindung kann das Steuersignal zum Herstellen der normalerweise offenen Verbindung extern erzeugt und an die Schaltung bereitgestellt werden, um das Solarmodul einzuschalten. Alternativ kann das Steuersignal zum Unterbrechen der normalerweise geschlossenen Verbindung basierend auf einem oder mehreren Signalen von internen und/oder externen Sensoren erzeugt werden, um das Solarmodul abzuschalten.

Das Trenn-Element kann einen Schalter, beispielsweise einen Transistor oder Ähnliches umfassen, und das Bypass-Element kann eine Diode oder eine Diode mit einem parallel angeordneten Schalter umfassen.

Ausführungsbeispiele der Erfindung schaffen ein Verfahren zum Steuern eines Solarmoduls, das durch ein Bypass-Element überbrückt ist, wobei das Verfahren folgende Schritte umfasst:
Bestimmen, ob das Solarmodul ganz oder teilweise abgeschattet ist, oder ob ein Abschalten des Solarmoduls erwünscht ist; und
falls bestimmt wird, dass das Solarmodul ganz oder teilweise abgeschattet ist oder abgeschaltet werden soll, Betreiben des Solarmoduls im Leerlauf.

Das Solarmodul kann Teil einer Reihenschaltung mit einer Mehrzahl von Solarmodulen sein, wobei das Betreiben des Solarmoduls im Leerlauf ein Trennen des Solarmoduls aus der Reihenschaltung umfasst. Ferner kann basierend auf den Leistungssignalen an einem Anschluss des Solarmoduls und basierend auf den Leistungssignalen an einem Anschluss der Reihenschaltung bestimmt werden, ob eine teilweise oder vollständige Abschattung des Solarmoduls vorliegt, wobei ferner vorgesehen sein kann, dass nach dem Bestimmen eines teilweise oder gänzlichen Abschattungszustandes überprüft wird, ob dieser noch anhält, um ggf. in einen Normalzustand zurückzuschalten.

Ausführungsbeispiele der vorliegenden Erfindung schaffen somit eine wünschenswerte Abschaltbarkeit bzw. gezielte Einschaltbarkeit eines Solarmoduls über ein externes oder internes Steuersignal, wobei ferner auch ein selbstständiges Abschalten des Moduls bei Erkennen unzulässiger Betriebszustände ermöglicht wird.

Ausführungsbeispiele der Erfindung schaffen eine Bypass- und Schutzschaltung für ein Solarmodul mit mindestens einem elektrischen Bypass-Element, dessen Schaltstrecke parallel zu den Ausgangsanschlüssen der Bypass- und Schutzschaltung geschaltet ist, wobei in Reihe mit einer der Verbindungsleitungen zwischen den Eingangsanschlüssen und den Ausgangsanschlüssen der Bypass- und Schutzschaltung mindestens ein steuerbares elektrisches Schaltelement liegt, welches durch eine Steuerschaltung angesteuert werden kann.

Gemäß diesem weiteren Aspekt kann als Schaltelement ein MOSFET eingesetzt werden. Ferner kann die zur Versorgung der Steuerschaltung benötigte Energie aus dem zugehörigen Solarmodul und/oder aus der Spannung über dem Bypass-Element bereitgestellt werden. Ferner kann ein. Energiepuffer zur Überbrückung kurzzeitiger Versorgungslücken vorgesehen sein. Für die Steuerschaltung kann ein Gleichspannungswandler zum Bereitstellen einer Versorgungsspannung vorgesehen sein. Die Bypass- und Schutzschaltung kann mittels einer Logikschaltung zwischen den Betriebszuständen "normal" und "Abschattung" unterscheiden, wobei das Schaltelement entsprechend ein- oder ausgeschaltet wird. Der Schalter kann ferner über ein externes Steuersignal aktiviert werden, um das Modul ein- und auszuschalten. Ein weiteres, steuerbares Schaltelement kann parallel zu dem Bypass-Element geschaltet sein, wobei das weitere Schaltelement ein MOSFET sein kann. Die Logikschaltung zur Unterscheidung zwischen den oben genannten Betriebszuständen ist ferner vorgesehen, um die beiden Schaltelemente entsprechend ein- oder auszuschalten. Ebenso können die Schalter über ein externes Steuersignal aktiviert werden, um das Modul ein- oder auszuschalten. Die Schaltung kann in Form einer integrierten Schaltung realisiert sein.

Andere Ausführungsbeispiele der Erfindung schaffen eine Bypass- und Schutzschaltung für ein Solarmodul mit mindestens einem elektrischen Bypass-Element, welches parallel zu den Ausgangsanschlüssen der Bypass- und Schutzschaltung geschaltet ist, und welches den von einem mit dem Solarmodul in Reihe verschalteten weiteren Solarmodul oder einer Vielzahl von in Reihe verschalteten Modulen erzeugten Strom leiten kann, wobei in einer oder beiden Verbindungsleitungen zwischen den Eingangsanschlüssen und den Ausgangsanschlüssen der Bypass- und Schutzschaltung ein steuerbares elektrisches Trenn-Element liegt, welches durch eine Steuerschaltung angesteuert werden kann.

Gemäß diesem wiederum weiteren Aspekt kann als Trenn-Element ein Transistor eingesetzt werden und die zur Versorgung der Steuerung erforderliche Energie kann aus der zugehörigen Solarzellenanordnung und/oder aus der Spannung über dem Bypass-Element bereitgestellt werden. Ferner kann ein Energiepuffer zur Versorgung der Steuerung vorgesehen sein. Ebenso kann ein Gleichspannungswandler zur Bereitstellung einer Versorgungsspannung der Steuerung vorgesehen sein. Mittels einer Logikschaltung kann zwischen den Betriebszuständen "normal" und "Abschattung" unterschieden werden, wobei das Trenn-Element entsprechend ein- oder ausgeschaltet werden kann. Ferner kann das Trenn-Element über ein externes und/oder internes Steuersignal aktiviert werden, und somit das Modul ein- oder ausgeschaltet werden. Als Bypass-Element kann eine Diode eingesetzt werden, wobei ein weiteres steuerbares Schaltelement parallel zu dem Bypass-Element geschaltet sein kann. Alternativ kann als Bypass-Element ein Schaltelement eingesetzt werden, welches beispielsweise ein Transistor ist. In diesem Fall erfolgt die Ansteuerung der zwei Schaltelemente durch die Logikschaltung oder durch ein internes und/oder externes Steuersignal, um das Modul ein- oder auszuschalten. Die Schaltung kann wiederum in Form einer integrierten Schaltung realisiert werden.

Nachfolgend werden Ausführungsbeispiele der vorliegenden Erfindung unter Bezugnahme auf die beiliegenden Zeichnungen näher erläutert, in denen:
- Fig. 1: ein Blockdiagramm einer Bypass- und Schutzschaltung gemäß einem Ausführungsbeispiel der Erfindung zeigt;
- Fig. 2: eine Bypass- und Schutzschaltung gemäß einem Ausführungsbeispiel der Erfindung zeigt;
- Fig. 3: ein Blockschaltbild einer Steuerung der Schaltung aus Fig. 2 gemäß einem Ausführungsbeispiel der Erfindung zeigt;
- Fig. 4: eine Bypass- und Schutzschaltung gemäß einem weiteren Ausführungsbeispiel der Erfindung zeigt;
- Fig. 5: ein Blockschaltbild einer Steuerung der Schaltung aus Fig. 4 gemäß einem weiteren Ausführungsbeispiel der Erfindung zeigt; und
- Fig. 6: ein Zustandsdiagramm zur Erläuterung der Funktionsweise der Steuerungen aus Fig. 3 und 5 zum Bestimmen, ob ein abgeschatteter Zustand eines Solarmoduls anhält, zeigt.

Bei der nachfolgenden Beschreibung der Ausführungsbeispiele der Erfindung werden gleiche oder gleichwirkende Elemente mit gleichen Bezugszeichen versehen.

Ausführungsbeispiele der Erfindung schaffen eine Bypass- und Schutzschaltung, die
- die Vorteile aktiver Schaltelemente zur Verminderung der Wärmeentwicklung im Abschattungsfall und zur optionalen gezielten Einschaltung von Solarmodulen nutzt, gleichzeitig aber einen deutlich geringeren Aufwand bei der Bereitstellung der intern benötigen Steuerspannung aufweist,
- die abgeschatteten Solarzellen im Leerlauf anstatt im Kurzschluss betreibt,
- kompatibel zu handelsüblichen Systemkomponenten, wie z.B. Wechselrichtern ist, und
- mit verlustarmen und kostengünstigen Bauelementen geringer Spannungsfestigkeit realisiert werden kann.

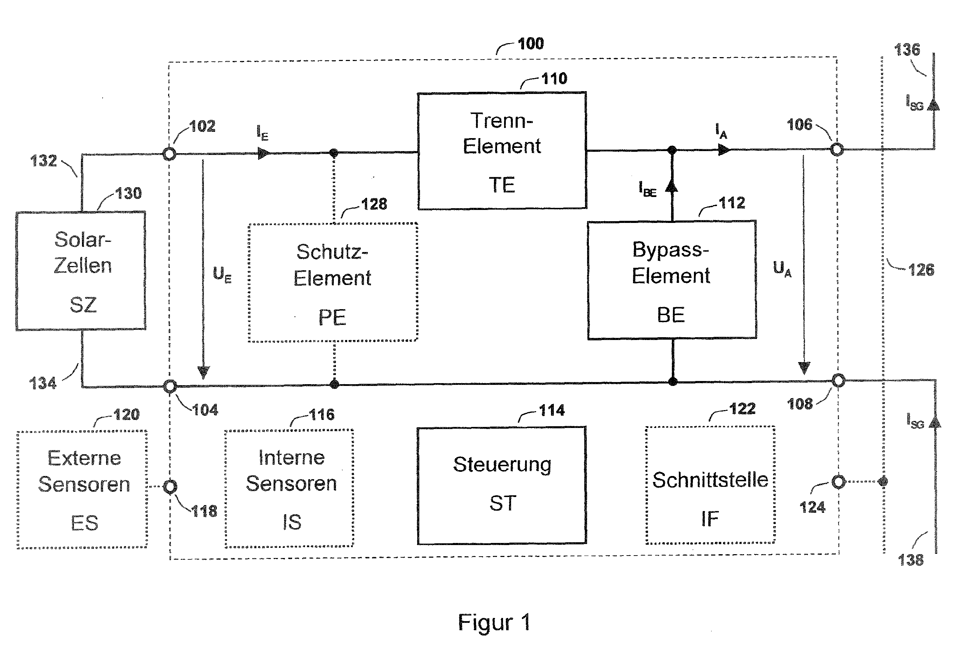

Fig. 1 zeigt ein Blockdiagramm einer Bypass- und Schutzschaltung 100 gemäß einem Ausführungsbeispiel der Erfindung. Die Bypass- und Schutzschaltung 100 umfasst zwei Eingangsanschlüsse 102 und 104 sowie zwei Ausgangsanschlüsse 106 und 108. Zwischen den ersten Eingangsanschluss 102 und den ersten Ausgangsanschluss 106 ist ein Trenn-Element (TE) 110 geschaltet. Zwischen den ersten Ausgangsanschluss 106 und den zweiten Ausgangsanschluss 108 ist ein Bypass-Element (BE) 112 geschaltet. Die Bypass- und Steuerschaltung kann ferner gemäß Ausführungsbeispielen eine Steuerung (ST) 114 umfassen, die später noch näher erläutert wird. Ferner kann die Schaltung 100 einen oder mehrere interne Sensoren (IS) 116 umfassen sowie einen weiteren Anschluss 118, der vorgesehen sein kann, um Signale von externen Sensoren (ES) 120 zu empfangen. Ferner kann eine Schnittstelle (IF) 122 vorgesehen sein. Zusätzlich kann ein Steueranschluss 124 zum Empfang eines externen Steuersignals, welches über eine externe Steuer- oder Kommunikationsleitung 126 bereitgestellt werden kann, vorgesehen sein. Zusätzlich zum Trenn-Element 110 und zum Bypass-Element 112 kann zwischen den ersten Eingangsanschluss 102 und den zweiten Eingangsanschluss 104 ein Schutzelement (PE) 128 geschaltet sein. Eine Solarzellenanordnung (SZ) 130 ist mit der Schaltung 100 verbindbar, wobei ein erster Anschluss der Solarzellenanordnung 130 über eine erste Leitung 132 mit dem ersten Eingangsanschluss 102 verbindbar ist, und wobei ein zweiter Anschluss der Solarzellenanordnung 130 über eine zweite Leitung 134 mit dem zweiten Eingangsanschluss 104 der Schaltung 100 verbindbar ist. Der erste Ausgangsanschluss 106 der Schaltung 100 ist mit einer ersten Anschlussleitung 136 verbunden, die zu einer weiteren Solarzellenanordnung 130 führt, wobei auch hier eine Schaltung 100, wie sie in der Fig. 1 gezeigt ist, vorgesehen sein kann. Der zweite Ausgangsanschluss 108 ist mit einer zweiten Anschlussleitung 138 verbunden, die zu einer vorhergehenden Solarzellenanordnung, die ebenfalls eine Schutzschaltung 100 aufweisen kann, führt. In einer alternativen Ausgestaltung der Schaltung 100 kann das Trenn-Element 110 auch in der negativen Verbindungsleitung zwischen dem zweiten Eingangsanschluss 104 und dem zweiten Ausgangsanschluss 108 angeordnet sein.

Bei der Bypass- und Schutzschaltung 100 gemäß Fig. 1 wird die über die beiden Leitungen 132, 134 an den Eingängen 102, 104 angeschlossene Solarzellenanordnung 130 im Abschattungsfall über das serielle Trenn-Element 110 von dem Ausgang 106, 108 abgetrennt. Der von den mit dem abgeschatteten Modul in Reihe geschalteten, nicht abgeschatteten Modulen in den äußeren Anschlussleitungen 136, 138 eingeprägte Solargeneratorstrom I_{SG} fließt dann über das parallel zu den Ausgangsklemmen 106, 108 angeordnete Bypass-Element 112 weiter. Anders als im Stand der Technik befinden sich die abgeschatteten Solarzellen somit im Leerlauf und sind vor Beschädigungen durch Überlastung (Hotspots) geschützt. Bei dieser Betriebsart wird ferner ermöglicht, die Anzahl der zu einer Bypass- und Schutzschaltung gehörigen, in Serie verschalteten Solarzellen von derzeit ca. 16 bis 24 Zellen zu erhöhen, wodurch insgesamt weniger Bypass- und Schutzschaltungen benötigt werden und sich die Modulfertigung vereinfacht, weil weniger Abgriffe an den innerhalb des Moduls in Serie verschalteten Zellen erforderlichen sind.

Bei der Bypass- und Schutzschaltung 100 gemäß Fig. 1 kann die zur Versorgung der Steuerung 114 erforderliche Spannung vorteilhafterweise aus der Eingangsspannung U_{E} der abgeschatteten Solarzellenanordnung 130 gewonnen werden und nicht, wie im Stand der Technik üblich, aus der sehr geringen Spannung U_{A} über dem Bypass-Element 112. Hierbei wird von der Eigenschaft der Solarzelle Gebrauch gemacht, dass zwar der verfügbare Strom bei der Abschattung sehr stark abnimmt, die Leerlaufspannung oder auch die Spannung bei geringer Belastung selbst bei einer extremen Abschattung nahezu der Spannung einer nicht abgeschatteten Zelle entspricht. Optional kann die Versorgungsspannung für die Steuerschaltung 114 auch aus der Spannung U_{A} über dem Bypass-Element 112 entsprechend den Ansätzen aus dem Stand der Technik oder auch aus beiden Quellen gewonnen werden.

Gegenüber dem in der DE 10 2006 060 816 A1 angegebenen Konzept ist die Bypass-Schaltung gemäß Ausführungsbeispielen der Erfindung vorteilhaft, da über dem seriellen Trenn-Element 110 maximal die von der zugeordneten Solarzellenanordnung 130 abgegebene Leerlaufspannung in Sperrrichtung auftreten kann, wodurch niederohmige, verlustarme und kostengünstige Schaltelemente zur Realisierung des Trenn-Elements 110 eingesetzt werden können. Neben den bisher erwähnten Hauptfunktionsgruppen, nämlich dem Trenn-Element 110, dem Bypass-Element 112 und der Steuerung 114 kann die Bypass- und Schutzschaltung 100 optional weitere Baugruppen umfassen, welche in der Fig. 1 gestrichelt dargestellt sind. Der Eingang 102, 104 kann durch das Schutzelement 128 gegen eine Verpolung oder eine Überspannung abgesichert sein. Die Steuerung 114 kann ferner mit den internen oder externen Sensoren 116 bzw. 120 verbunden sein, z.B. zur Erfassung der Temperatur der Schaltung selber oder der Solarzellenanordnung oder deren Umgebung. Über die Schnittstelle 122 kann eine uni- oder bidirektionale Kommunikation zwischen der Schaltung und weiteren Komponenten der Photovoltaikanlage bestehen. Diese Kommunikation kann über eine Power-Line-Communication (PLC) über die Leitungen 136, 138 erfolgen oder über die zusätzliche Kommunikationsleitung 126. Die Schaltung kann weitere Baugruppen, die z.B. zum Schutz einzelner Bauelemente der Schaltung vor Überspannung dienen, umfassen, sind jedoch der Übersichtlichkeit halber nicht dargestellt.

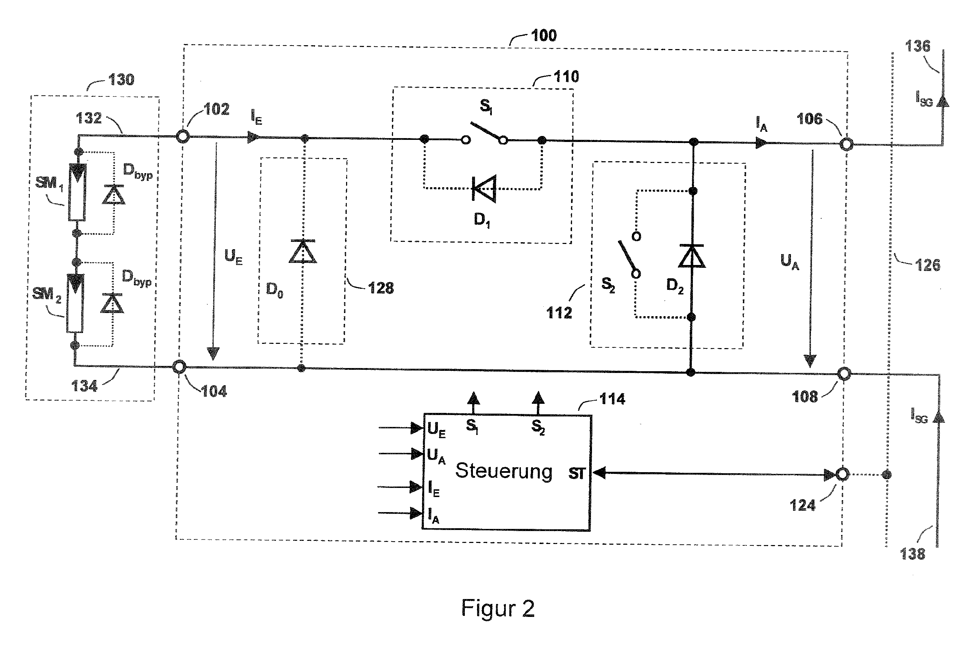

Die Fig. 2 zeigt eine Bypass- und Schutzschaltung gemäß einem Ausführungsbeispiel der Erfindung. Bei dem in Fig. 2 gezeigten Ausführungsbeispiel ist das Trenn-Element 110 durch eine Parallelschaltung aus einem Schalter S₁ und einer Diode D₁ realisiert. Das Bypass-Element ist ebenso durch eine Parallelschaltung aus einem Schalter S₂ und einer Diode D₂ realisiert. Das Schutzelement 128 ist in Form einer Diode D₀ realisiert. Die Steuerung 114 empfängt an einem Eingang die Spannung U_{E}. Ferner empfängt die Steuerung 114 ein Steuersignal ST, das über die Kommunikationsleitung 126 und den Steueranschluss 124 an die Schaltung 100 bereitgestellt wird, sowie die Ausgangsspannung U_{A}. Die Steuerung stellt entsprechende Signale zum Ansteuern der Schalter S₁ und S₂ bereit. Bei der Schaltung 100 gemäß der Fig. 2 wird die zur Versorgung der Steuerspannung 114 und zur Ansteuerung der aktiven Schaltelemente Sₛ und S₂ erforderliche Spannung nicht mehr aus der sehr geringen Spannung U_{A} über dem Bypass-Element 112 gewonnen, sondern aus der Eingangsspannung U_{E} des abgeschalteten Solarmoduls 130. Wie oben erwähnt, wird hierbei von der Eigenschaft der Solarzelle Gebrauch gemacht, dass zwar der Strom bei der Abschattung sehr stark abnimmt, die Leerlaufspannung oder auch die Spannung bei geringer Belastung auch bei externer Abschattung nahezu der Spannung einer nicht abgeschatteten Zelle entspricht. Bei der Schaltung 100 wird daher im Abschattungsfall der betroffene Teilgenerator (SM) 130 über den Serienschalter S₁ aus der Reihenschaltung der Module getrennt und somit, abgesehen von einem minimalen Eigenverbrauch der Steuerung 114, im Leerlauf betrieben. Der von den mit dem abgeschatteten Modulen in Reihe geschalteten, nicht abgeschatteten Modulen eingeprägte Solargeneratorstrom I_{SG} fließt über die Diode D₂ weiter, welche somit prinzipiell wie eine konventionelle Bypass-Diode wirkt. Gleichzeitig befinden sich die abgeschatteten Solarzellen nahezu im Leerlauffall und sind so vor Beschädigungen (Hotspots) geschützt.

Bei Solarmodulen mit geringen Strömen ist die in der Diode D₂ aufgrund ihrer Durchlassspannung entstehende Verlustwärme tolerabel. Bei höheren Stromstärken kann aber das oben genannte Problem der Überhitzung auftreten. Dieses wird dadurch gelöst, das parallel zur Diode D₂ der niederohmige Schalter S₂ geschaltet ist. Beim Auftreten einer Teilabschattung wird dieser nach einer weiter unten beispielhaft angegebenen Strategie eingeschaltet und übernimmt den Solargeneratorstrom I_{SG}, Entsprechend dem Durchlasswiderstand des Schalters S₂ tritt dann nur noch eine minimale Wärmeentwicklung auf. Gegenüber dem oben beschriebenen Stand der Technik gemäß der DE 10 2005 036 153 B4 ist der geringe Aufwand zur Bereitstellung der Versorgungsspannung für die Steuerung 114 vorteilhaft. Wie oben erwähnt, kann die Versorgungsspannung aber auch optional, ähnlich wie im Stand der Technik, aus der Spannung U_{A} über dem Bypass-Element D₂ bzw. S₂ gewonnen werden. In einer alternativen Ausgestaltung der Schaltung 100 gemäß Fig. 2 kann der Serienschalter S₁ auch in der negativen Verbindungsleitung zwischen dem zweiten Eingangsanschluss 104 und dem zweiten Ausgangsanschluss 108 liegen. Parallel zum Schalter S₁ kann die Diode D₁ geschaltet sein, die den Schalter S₁ vor negativen Sperrspannungen schützt. Optional kann die Diode D₀ als zusätzliche Sicherungsmaßnahme gegen negative Modulspannungen vorgesehen sein. Weitere, optionale Schutzelemente, z.B. gegen Überspannungen an den Ein- und Ausgängen der Bypass- und Schutzschaltung oder an den Schaltelementen selbst, sind der Übersichtlichkeit halber nicht dargestellt.

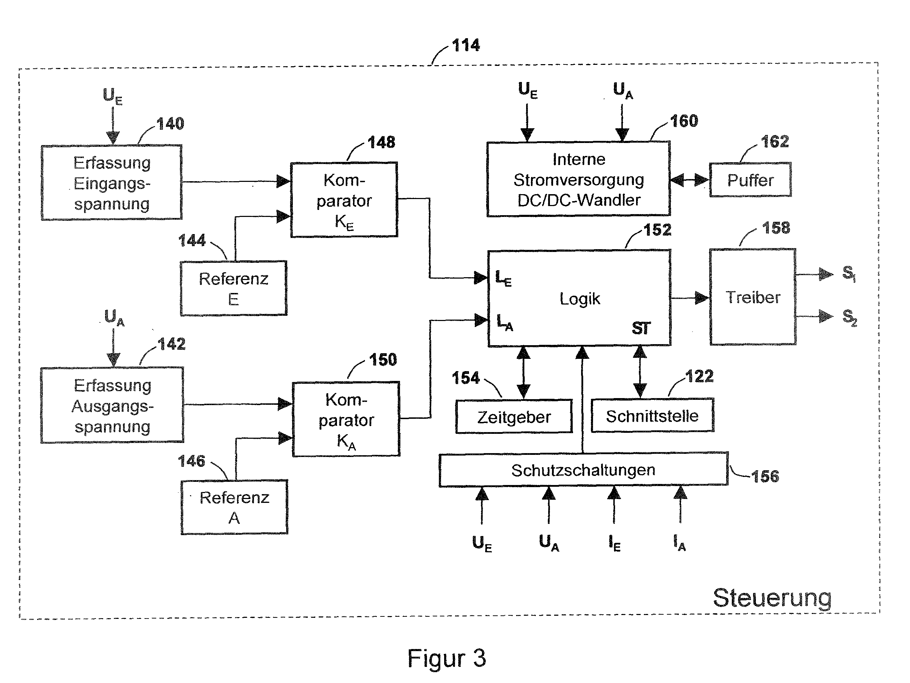

Die Fig. 3 zeigt ein Blockschaltbild der Steuerung 114 der Schaltung aus Fig. 2 gemäß einem Ausführungsbeispiel der Erfindung. Wie zu erkennen ist, umfasst die Steuerung 114 einen ersten Block 140, der die Eingangsspannung U_{E} empfängt und misst. Ferner umfasst die Steuerung 114 einen Block 142, der die Ausgangsspannung U_{A} empfängt und misst. Die Steuerung 114 umfasst ferner eine erste Referenzspannungsquelle (E) 144 sowie eine zweite Referenzspannungsquelle (A) 146. Ferner ist ein erster Komparator 148 und ein zweiter Komparator 150 vorgesehen. Der erste Komparator (K_{E}) 148 empfängt die von dem U_{E} Block 140 gemessene Eingangsspannung U_{E} sowie die Referenzspannung von der Referenzspannungsquelle 144 und gibt ein Signal L_{E} an eine Logikschaltung 152 aus. Der Komparator 150 empfängt das von dem U_{A} Block 142 gemessene Ausgangsspannungssignal sowie das Referenzspannungssignal von der Referenzspannungsquelle 146 und gibt an die Logikschaltung 152 das Komparatorausgangssignal L_{A} aus. Die Logik 152 empfängt ferner ein Zeitgeber-Signal von einem Zeitgeber 154 sowie ein Steuersignal ST von der Schnittstelle 122. Über Schutzschaltungen 156 empfängt die Logik 152 Signale, welche die Eingangsspannung U_{E}, die Ausgangsspannung U_{A}, den Eingangsstrom I_{E} und den Ausgangsstrom I_{A} angeben. Die Logik 152 umfasst über einen Treiber 158 die Ansteuersignale S₁ und S₂ zum Ansteuern der Schaltelemente S₁ und S₂ des Trenn-Elements 110 sowie des Bypass-Elements 112. Die Steuerung 114 umfasst ferner eine interne Stromversorgung 160, welche einen DC/DC-Wandler aufweisen kann. Die interne Stromversorgung 160 empfängt die Eingangsspannung U_{E} und/oder die Ausgangsspannung U_{A}. Die Stromversorgung 160 ist ferner mit einem Puffer 162, beispielsweise einem Kondensator oder Ähnlichem, verschaltet, um Energie auch in Zeiten bereitzustellen, in denen keine externe Energie bereitsteht.

Die Steuerung 114 umfasst die zwei Eingangsblöcke 140 und 142, mit denen sowohl die Eingangsspannung U_{E} (die Spannung des Solarmoduls SM) als auch die Ausgangsspannung U_{A} (sie Spannung über dem Bypass-Pfad S₂, D₂ - Fig. 2) gemessen wird. Beide Spannungen werden mittels den Komparatoren 148 und 150 mit den Referenzwerten E bzw. A verglichen. Die logischen Ausgangssignale L_{E}, L_{A} der Komparatoren 148 und 150 sind "1" wenn die jeweilige Messspannung über dem Referenzwert liegt. Die beiden Schaltsignale werden in der Logikschaltung 152 miteinander verknüpft, wobei diese Schaltung mit der Zeitgeberschaltung 150, den Schutzschaltungen 156 gegen Überströme und Überspannungen sowie optional mit einer Kommunikationsschnittstelle (Interface) 122 in Verbindung steht, so dass über die Treiberschaltungen 158 die beiden Schalter S₁ und S₂ angesteuert werden können. Die Versorgung der Steuerung 114 erfolgt aus der Eingangsspannung über die interne Stromversorgung 160, die über einen Gleichspannungswandler (DC/DC-Wandler, z.B. Ladungspumpe) verfügen kann, welcher aber aufgrund der vergleichsweise hohen Versorgungsspannung U_{E} deutlich einfacher aufgebaut sein kann als beim Stand der Technik. Ferner kann die Stromversorgung über einen Energiespeicher 162 zur Überbrückung transienter Versorgungslücken verfügen. Optional kann die Versorgungsspannung im Abschaltungsfall auch entsprechend dem Stand der Technik aus der Spannung U_{A} über dem Bypass-Element gewonnen werden.

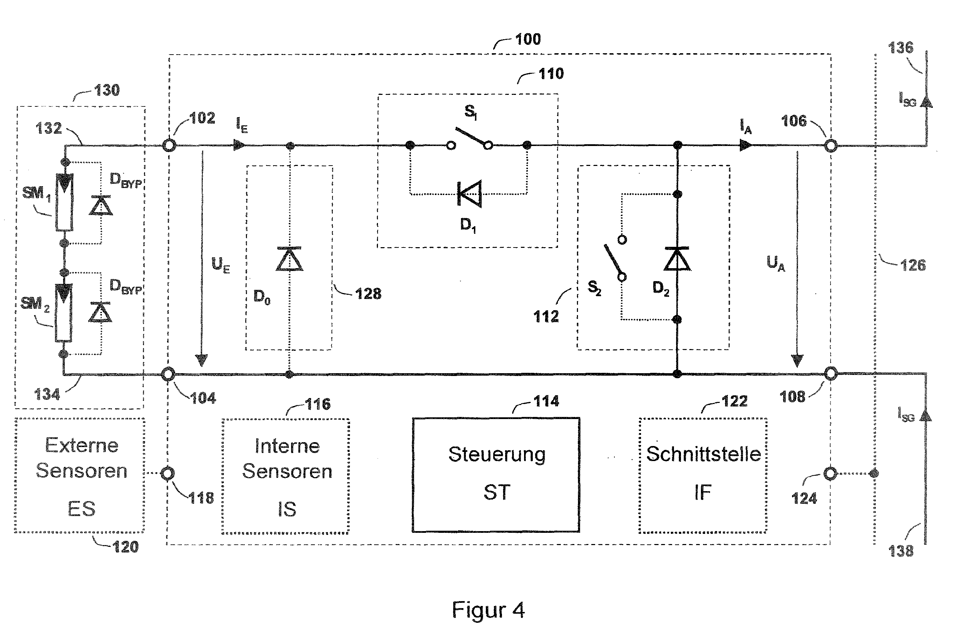

Anhand der Fig. 4 wird nachfolgend ein weiteres Ausführungsbeispiel der Erfindung erläutert. Die Fig. 4 zeigt eine Bypass- und Schutzschaltung gemäß einem Ausführungsbeispiel der Erfindung, wobei die Realisierung des Trenn-Elements 110, des Bypass-Elements 112 und des Schutzelements 128 der entspricht, die anhand der Fig. 2 beschrieben wurde. Die Schaltung 100 umfasst ferner die internen Sensoren 116, die Schnittstelle 122 und den Anschluss 118, um Signale von den externen Sensoren 120 zu empfangen. Die Solarzellenanordnung 130 umfasst zwei Solarmodule SM₁ und SM₂, die jeweils über zugeordnete Dioden D_{BYP} überbrückt sind. Die Funktionsweise der Schaltung 100 aus Fig. 4 entspricht der Funktionsweise der Schaltung aus Fig. 2, so dass auf eine erneute Beschreibung dieser hier verzichtet wird und stattdessen auf die obigen Ausführungen verwiesen wird.

Gemäß einer alternativen Ausführungsform kann bei der Schaltung gemäß Fig. 4 als Bypass-Element ausschließlich der Schalter S₂ eingesetzt werden, der auf die weiter unten beschriebene Art und Weise gesteuert wird. Als Schaltelemente S₁ und S₂ können Relais eingesetzt werden, bevorzugt jedoch Halbleiterbauelemente. Dabei können sowohl selbstsperrende als auch selbstleitende Bauelemente zum Einsatz kommen. Der Einsatz eines selbstleitenden Bauelements als Schalter S₂ bringt den Vorteil eines "Fail-Safe"-Verhaltens mit sich, d.h. beim Ausfall der Steuerung 114 würde der Schalter S₂ den Ausgang der Bypass- und Schutzschaltung kurzschließen und somit spannungsfrei schalten.

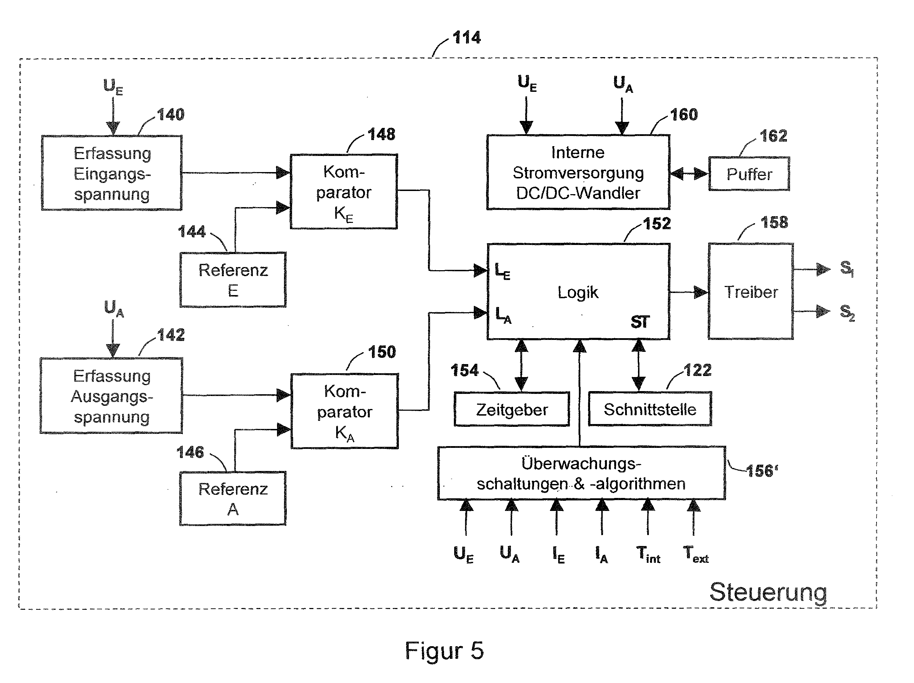

Fig. 5 zeigt ein Blockschaltbild der Steuerung 114 aus Fig. 4, wobei der Aufbau der Steuerung gemäß Fig. 5 im Wesentlichen dem Aufbau der Steuerung aus Fig. 3 entspricht, wobei jedoch anstelle der Schutzschaltungen 156 in Fig. 3 ein Block 156' angegeben ist, der Überwachungsschaltungen und -algorithmen beinhaltet, der ferner Temperatursignale Tᵢₙₜ und Tₑₓₜ empfängt, die eine interne Temperatur und eine externe Temperatur angeben. Die interne Stromversorgung 160 kann ferner Stabilisierungsschaltungen umfassen.

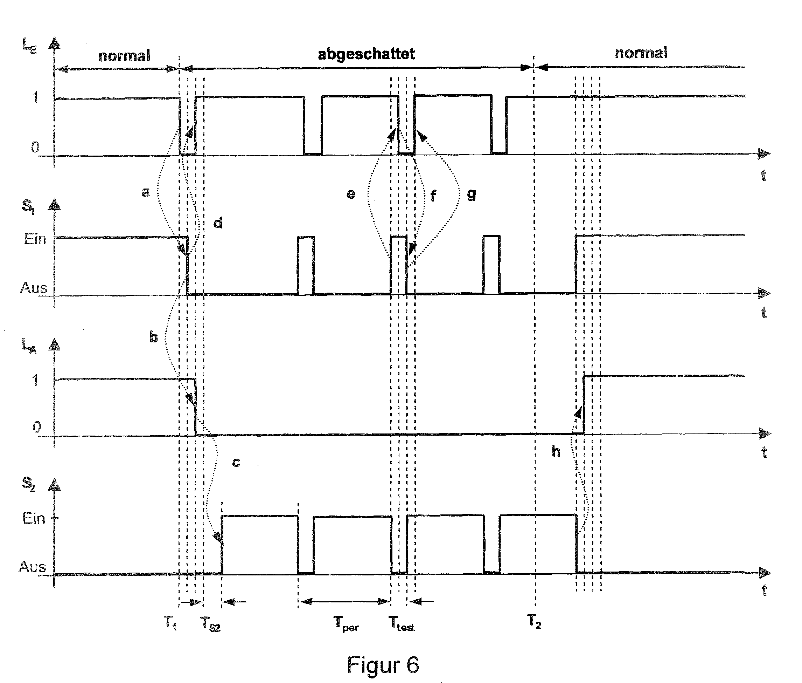

Nachfolgend wird anhand der Fig. 6 die Funktionalität der Steuerungen gemäß Fig. 3 und 5 zur Ansteuerung der Schalter S₁, und S₂ näher erläutert, insbesondere wird beschrieben, wie bestimmt wird, ob ein abgeschatteter Zustand des Solarmoduls noch anhält. Die folgende Beschreibung bezieht sich auf die Ausführungsform gemäß Fig. 2 und 4 mit einem zusätzlich schaltbaren elektrischen Bypass-Pfad über den Schalter S₂, ist sinngemäß aber auch auf die Variante ohne den Schalter S₂ oder die Variante ohne die Diode D₂ anzuwenden.

Wie oben erläutert wurde, wird bei einer Abschattung der Serienschalter S₁ geöffnet und der optionale Parallelschalter S₂ geschlossen. Nach der Aufhebung der Abschattungssituation würde dieser Betriebszustand ohne besondere Maßnahmen dauerhaft bestehen bleiben. Es muss also überprüft werden, ob die Aktivierung der Bypass-Funktion noch sinnvoll ist und entsprechend die Schalterstellungen von S₁ und S₂ gewählt werden. Dies kann gemäß Ausführungsbeispielen der Erfindung durch kurzzeitiges Herbeiführen bestimmter Konstellationen der Schalter S₁ und S₂ sowie einer Auswertung der an den Anschlüssen oder innerhalb der Bypass- und Schutzschaltung auftretenden Spannungen und Ströme erfolgen.

Dies erfolgt über die Steuerungen 114, die anhand der Fig. 3 und 4 dargestellt sind, deren Funktionalität nachfolgend anhand der Fig. 6 erläutert wird, die als Zustandsdiagramm die zeitlichen Zusammenhänge zwischen dem Komparatorsignal L_{E}, dem Schaltsignal S₁, dem Komparatorsignal L_{A} und dem Schaltsignal S₂ zeigt. Dargestellt sind in Fig. 6 sowohl der normale Betrieb ohne Abschattung, der Betrieb mit Abschattung als auch der Betrieb nach einem Übergang von der Abschattung zum normalen Betrieb.

Im normalen Betrieb liegen sowohl die Eingangsspannung als auch die Ausgangsspannung über den beiden Referenzwerten E und A, so dass beide Komparatorsignale auf einer logischen "1" sind. Entsprechend bewirkt die Logikschaltung 152, dass der Schalter S₁, eingeschaltet ist, und dass der Schalter S₂ ausgeschaltet ist. Der von der Solarzellenanordnung 130 erzeugte Eingangsstrom I_{E} wird nahezu verlustfrei über den niederohmigen Schalter S₁, an den Ausgang 106, 108 weitergeleitet.

Zum Zeitpunkt T₁ tritt eine Abschattung auf. Die Spannung über dem betroffenen Modul bricht zunächst zusammen, bis der Referenzwert E von z.B. +3 V erreicht ist. Das Signal L_{E} wechselt von logisch "1" auf "0". Über die Logikschaltung 152 wird der Schalter S₁ nach einer kurzen, schaltungsbedingten Verzögerungszeit geöffnet, was durch den Pfeil "a" dargestellt ist. Der von außen eingeprägte Solargeneratorstrom I_{SG} wird momentan von der Diode D₂ übernommen, wodurch die Ausgangsspannung U_{A} ihr Vorzeichen wechselt und auf die Durchlassspannung der Diode D₂ von z.B. -0,4 V bis -0,6 V begrenzt wird. In Folge wird der Referenzwert A des Komparators K_{A} von z.B. +0,1 V unterschritten, und dessen Ausgangssignal L_{A} wechselt nach einer geringen Verzögerungszeit ebenfalls von logisch "1" auf "0", was durch den Pfeil "b" dargestellt ist. Dies führt entweder unmittelbar oder nach dem Ablauf einer Verzögerungszeit T_{S2} zu dem Einschalten des Bypass-Elements S₂, welches dann den Strom I_{SG} übernimmt und dabei nahezu keine Verlustwärme produziert. Die Verzögerungszeit T_{S2} kann so eingestellt sein, um den beschriebenen Einschaltvorgang des Schalters S₂ bei kurzen Teilabschattungen, z.B. beim Überflug eines Vogels, zu verhindern.

Das Öffnen des Schalters S₁ bewirkt - wie eingangs dargestellt - ein schnelles Wiederansteigen der Spannung U_{E} auf Werte von mehreren Volt, so dass zum einen das Ausgangssignal L_{E} des Komparators K_{E} wider eine logische "1" annimmt (siehe Pfeil "d"), und zum anderen wird die Versorgung der Steuerung 114 dauerhaft sichergestellt. Die Versorgung der Schaltung kann während der beschriebenen Umgangvorgänge aus dem Energiepuffer 162 erfolgen, der z.B. als Kondensator ausgebildet ist.

Der sich nach einer Abschattung einstellende stabile Zustand der Anordnung würde auch nach einer Aufhebung der Abschattung bestehen bleiben. Es ist daher zu prüfen, ob die Abschattungssituation noch besteht und die Schalterstellungen sind entsprechend anzupassen. Bei einem Ausführungsbeispiel bewirkt die Logikschaltung 152 unter Verwendung der Zeitgeberschaltung (Timer) 154, dass der Schalter S₂ periodisch mit einer Periodendauer Tₚₑᵣ für eine Zeitdauer Tₜₑₛₜ geöffnet und gleichzeitig der Schalter S₁ geschlossen wird. Liegt weiterhin eine Abschattungssituation vor (der von außen eingeprägte Strom I_{SG} ist größer als der von der betroffenen Solarzellenanordnung 130 erzeugte Eingangsstrom I_{E}), so stellt sich nach diesem Prüfpuls wieder die alte Konstellation ein, was beispielhaft im mittleren Abschnitt der Fig. 6 dargestellt ist. Die Periodendauer Tₚₑᵣ ist gemäß Ausführungsbeispielen deutlich größer gewählt als die Dauer des Testpulses Tₜₑₛₜ (z.B. um den Faktor 5 oder mehr größer), so dass die mittlere Verlustleistung in der Diode D₂ nach wie vor gering bleibt.

In Fig. 6 wird zum Zeitpunkt T₂ die Abschattung aufgehoben. Entsprechend bricht beim nächsten Prüfpuls die Eingangsspannung nicht mehr zusammen, das Signal L_{E} bleibt auf einer logischen "1" und auch der Schalter S₁ bleibt eingeschaltet. Die Ausgangsspannung U_{A} steigt über den Referenzwert A, so dass das Signal L_{A} ebenfalls auf eine logischen "1" wechselt und der Schalter S₂ geöffnet bleibt, so dass wieder der stabile normale Betrieb erreicht ist.

Die gemäß den Ausführungsbeispielen der Erfindung beschriebene Bypass- und Schutzschaltung können einfach als integrierte Schaltung realisiert werden, da keine aufwendigen DC/DC-Wandlerschaltungen erforderlich sind. Sie können in einem kleinen Volumen untergebracht werden und daher in das Solarmodul selbst einlaminiert werden. Die Schaltungen können aber auch in der Modulanschlussbox eingebaut sein oder als externe Baueinheit mit konventionellen Modulen verschaltet sein. Wie anhand der Fig. 4 gezeigt ist, können die mit der Bypass- und Schutzschaltung verbundenen Solarzellen/Solarmodule selbst wieder über Bypass-Dioden D_{BYP} verfügen, die als konventionelle Dioden oder als aktive Schaltungen ausgeführt sein können.

Die Bypass- und Schutzschaltung gemäß Ausführungsbeispielen der Erfindung kann auf einfache Art und Weise dahin gehend erweitert werden, dass über ein externes Steuersignal ST, welches entweder über die Anschlussleitungen 136, 138 (Power Line-Übertragung) oder über die zusätzliche Kommunikationsleitung 126 oder auch drahtlos per Funk oder über magnetische Felder übertragen wird, das Modul 130 gezielt eingeschaltet werden kann. Hierbei wird der im nicht eingeschalteten Zustand offene Schalter S₁ geschlossen. Der Schalter S2 kann im nicht eingeschalteten Zustand entweder dauerhaft geöffnet oder optional geschlossen sein, und wird bei einer Aktivierung des Moduls entsprechend der oben dargestellten Strategie angesteuert. Das gezielte Einschalten der Module über ein Steuersignal kann genutzt werden zur gefahrlosen Installation oder Wartung, zur Abschaltung im Falle eines Brandes oder auch mit entsprechend codierten Einschaltsignalen zum Diebstahlschutz. Die Kommunikationsschnittstelle 122 kann auch bidirektional ausgeführt sein, um Statussignale von dem Solarmodul zu externen Auswertegeräten zu übertragen.

Die Abschaltung des Moduls kann weiterhin auch innerhalb der Schaltung mittels der internen und/oder externen Sensoren erfolgen. Hierzu zählen die Abschaltung bei Überstrom oder Überspannung, bei überhöhter Temperatur Tᵢₙₜ der Schaltung selber oder Tₑₓₜ des Moduls oder dessen Umgebung, oder auch die Detektion unerlaubter Betriebszustände wie z.B. Unterbrechungen oder Wackelkontakte innerhalb des Solargenerators.

Gemäß Ausführungsbeispielen der Erfindung können die Bypass- und Schutzschaltungen für kleine Ströme ohne den Schalter S₂ realisiert sein, da hier die Funktion des aktiven Bypass-Schalters S₂ zur Verminderung der Wärmeentwicklung nicht zwingend erforderlich ist, sondern die Bypass-Diode D₂ ausreichend ist. Dies führt zu einer Kosteneinsparung, wobei die Schutzfunktion sowie die Möglichkeit eines gezielten Ein- und Ausschaltens des Moduls über die extern oder intern gewonnen Signale erhalten bleibt.

Bei den beschriebenen Ausführungsbeispielen umfasst das Bypass-Element eine Parallelschaltung aus einem Schalter S₂ und einer Diode D₂. Alternativ kann, wie z.B. in der DE 10 2005 036 153 B4 beschrieben ist, eine aktive Bypass-Diode verwendet werden, die nicht als Schalter betrieben wird. Die Versorgungsspannung wird ausschließlich aus der (geringen) Spannung über dem Bypass-Element gewonnen, wobei das Bypass-Element (MOSFET) über eine Regelschaltung dauerhaft im linearen Betrieb gehalten wird (bei z. B. 50 mV Spannung über dem MOSFET).

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Bypass- und Schutzschaltung (100) für ein Solarmodul (130), mit:
einem Eingang (102, 104) zum Anschluss des Solarmoduls (130);
einem Ausgang (106, 108);
einem Bypass-Element (112), das parallel zu dem Ausgang (106, 108) geschaltet ist;
einem Trenn-Element (110), das zwischen den Eingang (102, 104) und den Ausgang (106, 108) geschaltet ist und konfiguriert ist, um die Verbindung zwischen dem Eingang (102, 104) und dem Ausgang (106, 108) zu steuern, wobei das Trenn-Element (110) konfiguriert ist, eine Verbindung zwischen dem Eingang (102, 104) und dem Ausgang (106, 108) abhängig davon zu steuern, ob das der Schaltung (100) zugeordnete Solarmodul (130) ganz oder teilweise abgeschattet ist; und
einer Steuerung (114), die wirksam mit dem Trenn-Element (110) verbunden ist und konfiguriert ist, um ein Steuersignal für das Trenn-Element (110) zu erzeugen, wobei die Steuerung (114) konfiguriert ist, um basierend auf den am Eingang und am Ausgang anliegenden Leistungssignalen zu bestimmen, ob eine teilweise oder vollständige Abschattung des der Schaltung (100) zugeordneten Solarmoduls (130) vorliegt, und um das Steuersignal zu erzeugen, falls bestimmt wird, dass das der Schaltung (100) zugeordnete Solarmodul (130) ganz oder teilweise abgeschattet ist.

2. Bypass- und Schutzschaltung nach Anspruch 1, bei der das Steuersignal (ST) eine Unterbrechung der normalerweise geschlossenen Verbindung zwischen dem Eingang (102, 104) und dem Ausgang (106, 108) bewirkt, wenn das der Schaltung (100) zugeordnete Solarmodul (130) ganz oder teilweise abgeschattet ist.

3. Bypass- und Schutzschaltung gemäß Anspruch 1 oder 2, die mit dem Solarmodul (130) derart verschaltbar ist, dass ein Unterbrechen der Verbindung zwischen dem Eingang (102, 104) und dem Ausgang (106, 108) durch das Trenn-Element (110) einen Leerlauf des Solarmoduls (130) bewirkt.

4. Bypass- und Schutzschaltung nach einem der Ansprüche 1 bis 3, bei der die Steuerung (114) einen Leistungsversorgungsanschluss umfasst, der mit dem Eingang (102, 104) verbunden ist.

5. Bypass- und Schutzschaltung nach einem der Ansprüche 1 bis 4, bei der das Bypass-Element (112) konfiguriert ist, um durch ein weiteres Steuersignal angesteuert zu werden, wobei die Steuerung (114) konfiguriert ist, um das weitere Steuersignal zu erzeugen, falls bestimmt wird, dass das der Schaltung zugeordnete Solarmodul (130) ganz oder teilweise abgeschattet ist.

6. Bypass- und Schutzschaltung nach einem der Ansprüche 1 bis 5, bei der die Steuerung konfiguriert ist, um nach dem Bestimmen, dass das der Schaltung (100) zugeordnete Solarmodul (130) ganz oder teilweise abgeschattet ist, zu prüfen, ob die Abschattungssituation noch andauert, und um in den Normalzustand zu schalten, falls bestimmt wird, dass die Abschattungssituation nicht mehr andauert.

7. Bypass- und Schutzschaltung nach einem der 1 bis 6, bei der das Trenn-Element (110) einen Schalter (S₁) umfasst, und bei der das Bypass-Element (112) eine Diode (D₂) oder eine Diode (D₂) mit einem parallel angeordneten Schalter (S₂) umfasst.

8. Verfahren zum Steuern eines Solarmoduls (130), das durch ein Bypass-Element (112) überbrückt ist, wobei das Verfahren folgende Schritte umfasst:
Bestimmen, ob das Solarmodul (130) ganz oder teilweise abgeschattet ist; und
falls bestimmt wird, dass das Solarmodul (130) ganz oder teilweise abgeschattet ist werden soll, Betreiben des Solarmoduls (130) im Leerlauf,
wobei basierend auf Leistungssignalen an einem Anschluss des Solarmoduls (130) und basierend auf Leistungssignalen an einem Anschluss der Reihenschaltung bestimmt wird, ob eine teilweise oder vollständige Abschattung des Solarmoduls (130) vorliegt.

9. Verfahren nach Anspruch 8, bei dem das Solarmodul Teil einer Reihenschaltung einer Mehrzahl von Solarmodulen ist, wobei das Betreiben des Solarmoduls (130) im Leerlauf eine Unterbrechung der normalerweise geschlossenen Verbindung zwischen dem Eingang (102, 104) und dem Ausgang (106, 108) umfasst.

10. Verfahren nach Anspruch 8 oder 9, bei dem nach dem Bestimmen, dass das Solarmodul ganz oder teilweise abgeschattet ist, geprüft wird, ob die Abschattungssituation noch andauert, wobei in den Normalzustand geschaltet wird, falls bestimmt wird, dass die Abschattungssituation nicht mehr andauert.
